Europäisches Patentamt

European Patent Office

Office européen des brevets

(11) Publication number: **0 025 077**
**B1**

(12) **EUROPEAN PATENT SPECIFICATION**

(45) Date of publication of patent specification: 06.06.84

(21) Application number: 79810088.9

(22) Date of filing: 06.09.79

(51) Int. Cl.³: **G 08 C 19/12,**
**G 01 L 23/00, G 01 R 29/00**

(54) A two-wire remote measuring system.

(43) Date of publication of application:
**18.03.81 Bulletin 81/11**

(45) Publication of the grant of the patent:
**06.06.84 Bulletin 84/23**

(84) Designated Contracting States:
**CH DE FR GB IT NL SE**

(56) References cited:
**DE - B - 2 429 440**
**US - A - 3 959 786**
**US - A - 4 015 472**

(73) Proprietor: **VIBRO-METER SA**
**Route de Moncor 4**
**CH-1700 Fribourg (CH)**

(72) Inventor: **Bourqui, Gérald**
**Chemin de la Forêt 6**
**CH-1752 Villars-sur-Glâne (CH)**
Inventor: **Jordan, Yvan**
**Route de la Veveyse 24**
**CH-1700 Fribourg (CH)**

(74) Representative: **Steiner, Martin et al,**
**c/o AMMANN PATENTANWAELTE AG BERN**
**Schwarztorstrasse 31**
**CH-3001 Bern (CH)**

## Description

This invention relates to a two-wire remote measuring system with galvanic separation and of particular simplicity.

Measuring systems fulfilling the requirements of intrinsic safety (PTB) may include galvanic separation of the power source and electronic circuits on one hand, and of the measuring element or probe on the other hand, by electro-optical couplers or transformers, and they include two converters or transformers, for energizing the measuring element, and for transmitting a signal corresponding to the measured value respectively.

US—A—4,015,472 discloses a two-wire transmission system for a vortex flow-meter whose sensor generates a low-level a-c signal having a frequency that depends on flow-rate. The signal is fed to a preamplifier which is supplied with d-c power from a remote source by the two-wire system which includes a DC-to-DC convertor comprising a high frequency oscillator connected to the primary of a transformer the secondary of which is connected to a rectifier supplying the d-c power for the preamplifier. Connected across the preamplifier is a load resistor which draws sufficiently heavy current to modulate the d-c power consumed by the preamplifier in accordance with the a-c flow-meter signal. These modulations are reflected in the d-c source through the two-wire line and detected at this remote point. However, such a two-wire transmission system permits measurement only of the frequency of the a-c signal detected at the remote point and does not permit high accuracy and linearity of the measurement.

This invention aims to provide a two-wire remote measuring system of high simplicity, linearity and intrinsic safety.

The measuring system according to this invention comprises a transformer, a direct current supply circuit connected to a primary circuit of said transformer and an oscillator connected to said primary circuit for providing DC-pulses from said supply to a primary winding of said transformer at a frequency exceeding the frequency of dynamic phenomena to be measured, a variable-impedance measuring means connected to a secondary winding of said transformer and means for measuring the current flow in said primary circuit, this current flow being indicative for the impedance of said measuring means, characterized in that said direct current supply circuit is stabilized in voltage such that its voltage is independent of said current flow in said primary winding, a field effect transistor is series-connected in said primary circuit with said primary winding, the gate of said transistor being connected to said oscillator such that this oscillator is not loaded by said primary circuit and thus independent of said current flow in the primary circuit. It has been found that such a measuring system has an excellent linearity, intrinsic safety due to the galvanic separation of the measuring element from the remaining measuring circuits and from the power source, low power rating, and simplicity due to the fact that one transformer only is required. Since the system measures the current flowing in the primary circuit, this current depending on the current flowing in the secondary circuit including the measuring element, it is important to perfectly stabilize the voltage so that the current flow in the primary circuit does not depend on this voltage but only on the impedance of the measuring element. Zener diodes or similar elements are connected in parallel to the power input in the primary circuit and in parallel to the measuring circuit or secondary circuits in order to cut off and prevent any excessive voltage peaks and power transfer in each of these circuits, whereby intrinsic safety is ensured.

Preferably the frequency of pulses delivered to the primary winding of the transformer should be relatively high, for instance in the order of 200 kHz, this allowing measurement of dynamic phenomena up to relatively high frequencies, in the order of 50 kHz, without significant attenuation. Further, due to the relatively high operating frequency a transformer having relatively small numbers of turns and having thus a low capacitance may be used, this being particularly favourable because differences in voltage between the primary and secondary circuits are practically without effect. It is also relatively easy to obtain insulation of the windings of the transformers for high voltages, for instance up to 4000 V.

In order to reduce the effects of the impedance of the transmission line between the secondary transformer winding and the measuring element, an impedance converter is preferably connected to the secondary winding allowing transmission and reading of the measuring current signal at low impedance.

The system may operate at a very low power level in the secondary or measuring circuit, this being in agreement with international standards for intrinsic safety.

Further details of the invention will now be explained with reference to the accompanying drawing showing by way of example an embodiment of the measuring system and wherein

Fig. 1 is a circuit diagram and

Fig. 2 schematically shows the principle of measurement in a modified embodiment.

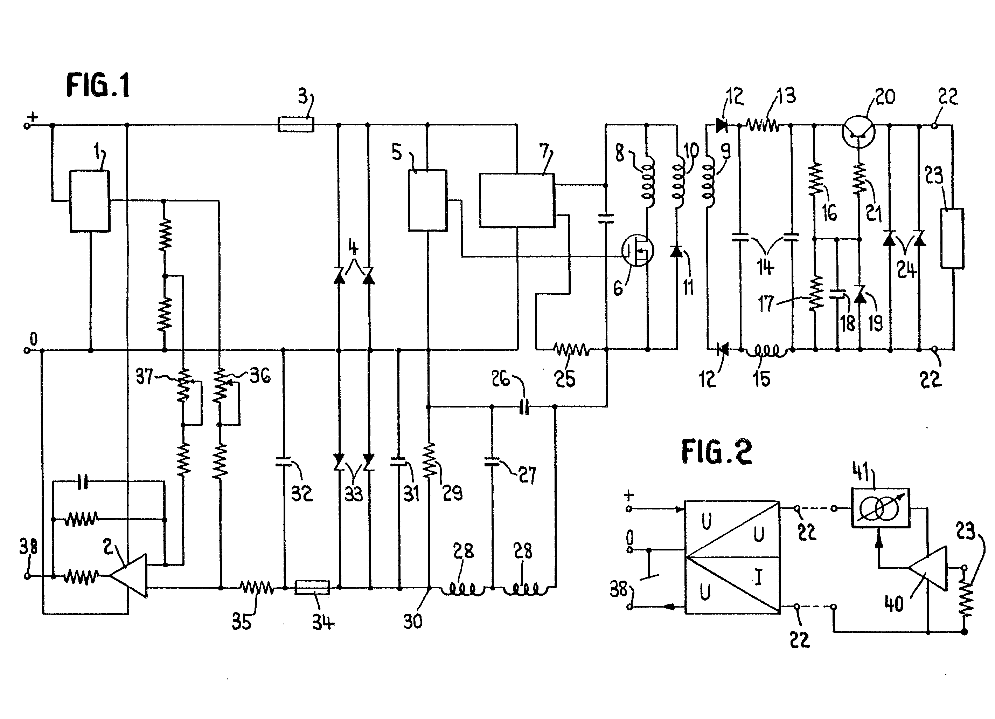

The circuit shown in Fig. 1 has power input terminals + and 0 for a suitable voltage, for example 24 V. A first stabilizing circuit 1 delivers a stable output voltage at a suitable level for being applied to inputs of a DC measuring amplifier 2 in a manner explained below. Input + is connected through a fuse 3 to two Zener diodes 4 serving to prevent undesired voltage peaks at the power input. The system comprises an oscillator 5 operating at high frequency, for instance 200 kHz. The output of oscillator 5 is connected to the gate of a VMOS-transistor 6. Connected to the input power terminals is a second voltage stabilizer 7 having a very stable output of low impedance, such that the voltage is independent of the current consumed. The output of stabilizer 7 is connected to a primary winding 8 of a high-frequency transformer, winding 8 being connected in series with transistor 6. The transformer further has a secondary winding 9 and an intermediate recuperation winding 10 connected in series with a diode 11. The secondary winding 9 is connected via diodes 12 to a filter comprising a resistor 13, capacitors 14 and an inductor 15. The high frequency signal induced in secondary winding 9 is thus rectified and a direct voltage of constant value is fed to an impedance transformer having a voltage divider comprising resistors 16 and 17, a capacitor 18 and a Zener diode 19 in parallel with resistor 17, a transistor 20 and a base resistor 21. A direct current measuring element 23 having a variable resistance, such as a strain guage or other, is connected to the output terminals 22 of the impedance transformer. Zener diodes 24 are connected in parallel with the output terminals 22 for cutting off any voltage peaks which might appear at these terminals. A relatively long two-wire transmission line may be connected between terminals 22 and the measuring element 23.

The pulsating current flowing through transistor 6 also flows through a measuring resistor 25 connected in series with transistor 6 and primary winding 8 respectively. A low-pass filter comprising capacitors 26 and 27, inductors 28 and a resistor 29 is connected in parallel with the measuring resistor 25, a direct voltage corresponding to the mean voltage drop at the measuring resistor 25 appearing at the output 30 of the filter. This voltage is further filtered by capacitors 31 and 32 and possible voltage peaks are cut off by Zener diodes 33. The voltage at the output 30 is transmitted to the one input terminal of amplifier 2 through a fuse 34 and a resistor 35, the DC-level at this input being adjusted by means of a potentiometer 36. The gain of the amplifier 2 is adjusted by another potentiometer 37 connected to the other input. The output of amplifier 2 is the output 38 of the measuring system.

As explained above, pulses of constant voltage are applied to the primary winding 8 of the transformer at high frequency, for instance 200 kHz, and the voltage induced in the secondary winding is rectified and applied to the measuring element 23. The impedance of the primary winding 8 depends on the current flow in the secondary winding 9, and this current flow depends on the current flow in the measuring element 23. If no measuring element is connected there will be no current, the impedance at the primary winding 8 is high and the current flowing therein is low. It has been found that with the system as described the mean current flowing in the primary winding is a linear function of the value of the measuring element 23 over a wide range of measurement. The voltage peaks induced in the intermediate winding 10 of the transformer when the current in the primary winding 8 is chopped by transistor 6 are cut off by current flow through diode 11 and intermediate winding 10 whereby energy is recuperated and the energy consumption of the system is reduced.

Fig. 2 schematically illustrates the principle of the measuring system. A DC-supply voltage is transmitted to the measuring element through a DC-DC-converter U/U and the current flowing in the measuring element is transmitted through a current-voltage-converter I/U to the measuring amplifier and output 38 of the system. The terminals and broken lines in Fig. 2 indicate that a cable of desired length may be connected between the measuring circuits and the measuring element. Fig. 2 further shows that a controlled current source may be provided instead of a simple measuring element. In this case the measuring element 23 which may be an active element such as a piezoelectric crystal or the like is connected to the input of an amplifier 40 of which the output controls the current source 41. With such a controlled current source the system becomes substantially independent of fluctuations of the operating voltage.

The measuring system as herein described may be used for measuring quasi static as well as dynamic phenomena at frequencies up to about 50 kHz if the operating frequency is of the order of 200 kHz. Passive measuring elements such as strain gauges or active elements such as piezoelectric crystals may be used. The operating frequency may be increased in order to measure dynamic phenomena of higher frequencies.

**Claims**

1. A two-wire remote measuring systems comprising a transformer (8—10), a direct current supply circuit (7) connected to a primary circuit of said transformer and an oscillator (5) connected to said primary circuit for providing DC-pulses from said supply to a primary winding (8) of said transformer at a frequency exceeding the frequency of dynamic phenomena to be measured, a variable-impedance measuring means (23) connected to a secondary winding (9) of said transformer and means for measuring the current flow in said primary circuit, this current flow being indicative for the impedance of said measuring means, characterized in that said direct current supply circuit (7) is stabilized in voltage such that its voltage is independent of said current flow in said primary winding (8), a field effect transistor (6) in series-connected in said primary circuit with said primary winding (8), the gate of said transistor (6) being connected to said oscillator (5).

2. A system according to claim 1, wherein said field effect transistor is a VMOS transistor (6).

3. A system as claimed in claim 1 or 2, wherein voltage limiting elements such as Zener diodes (4, 24) are connected into said supply circuit (7) and in parallel with said measuring means (23) for cutting off any undesired voltage peaks at the power input of the system and across the measuring means.

4. A system according to any one of claims 1 to 3, wherein a resistor (25) connected into said primary circuit is connected to a low-pass filter (26—29) producing at its output a DC voltage proportional to the current flow in said primary circuit and resistor respectively.

5. A system according to claim 4, wherein voltage limiting elements such as Zener diodes (33) are connected into the output circuit of said low-pass filter (26—29) for cutting off excess voltage peaks.

6. A system according to any one of claims 1 to 5, wherein an impedance transformer (16—21) is connected between the secondary winding (9) and the measuring means (23).

7. A system according to any one of claims 1 to 6, wherein a rectifier (12—15) is connected to said secondary winding (9), the measuring means (23) being energized with the rectified DC voltage.

8. A system according to any one of claims 1 to 7, wherein said measuring means comprise a controllable current source (41), a measuring circuit (23, 40) being connected to the control input of this current source.

9. A system according to any one of claims 1 to 8, wherein said transformer (8—10) has a third winding (10) in series with a diode (11), the series connection of this third winding and diode being connected in parallel to the primary winding (8) for recuperation of current and cutting off voltage peaks during collapse of the current in the primary winding.

## Revendications

1. Dispositif de mesure à distance à deux fils, comprenant un transformateur (8—10), un circuit d'alimentation en courant continu (7) connecté à un circuit primaire du transformateur et un oscillateur (5) connecté au circuit primaire pour délivrer à partir de l'alimentation des impulsions de courant continu à un enroulement primaire (8) du transformateur à une fréquence excédant la fréquence des phénomènes dynamiques à mesurer, des moyens de mesure à impédance variable (23) connectés à un enroulement secondaire (9) du transformateur et des moyens pour mesurer le courant coulant dans le circuit primaire, ce courant étant indicatif de l'impédance des moyens de mesure, caractérisé en ce que le circuit d'alimentation en courant continu (7) est stabilisé en tension de manière que sa tension est indépendante du courant dans l'enroulement primaire (8) et en ce qu'un transistor à effet de champ (6) est connecté en série dans le circuit primaire avec l'enroulement primaire (8), la porte du transistor (6) étant connectée à l'oscillateur (5).

2. Dispositif selon la revendication 1, caractérisé en ce que le transistor à effet de champ est un transistor VMOS (6).

3. Dispositif selon l'une des revendications 1 ou 2, caractérisé en ce que des éléments limiteurs de tension tels que des diodes Zener (4, 24) sont connectés dans le circuit d'alimentation (7) et en parallèle avec les moyens de mesure (23) pour couper toutes les pointes de tension indésirables à l'entrée de puissance du dispositif et sur les moyens de mesure.

4. Dispositif selon l'une des revendications 1 à 3, caractérisé en ce qu'une résistance (25) connectée dans le circuit primaire est connectée à un filtre passe-bas (26—29) pour produire à sa sortie une tension continue proportionnelle au courant coulant respectivement dans le circuit primaire et dans la résistance.

5. Dispositif selon la revendication 4, caractérisé en ce que des éléments limiteurs de tension tels que des diodes Zener (33) sont connectés dans le circuit de sortie du filtre passe-bas (26—29) pour couper les pointes de tension en excès.

6. Dispositif selon l'une quelconque des revendications 1 à 5, caractérisé en ce qu'un transformateur d'impédance (16—21) est connecté entre l'enroulement secondaire (9) et les moyens de mesure (23).

7. Dispositif selon l'une quelconque des revendications 1 à 6, caractérisé en ce qu'un redresseur (12—15) est connecté à l'enroulement secondaire (9), les moyens de mesure (23) étant alimentés par la tension continue redressée.

8. Dispositif selon l'une quelconque des revendications 1 à 7, caractérisé en ce que les moyens de mesure comprennent une source de courant contrôlable (41), un circuit de mesure (23, 40) étant connecté à l'entrée de contrôle de cette source de courant.

9. Dispositif selon l'une quelconque des revendications 1 à 8, caractérisé en ce que le transformateur (8—10) a un troisième enroulement (10) en série avec une diode (11), la connection en série de ce troisième enroulement et de cette diode étant connectée en parallèle avec l'enroulement primaire (8) pour la récupération du courant et pour couper les pointes de tension pendant la disparition du courant dans l'enroulement primaire.

## Patentansprüche

1. Zweidraht-Fernmesssystem mit einem Transformator (8—10), einem Gleichstromspeisestromkreis (7) welcher mit einem Primärkreis des genannten Transformators verbunden ist, und einem Oszillator (5) der mit dem genannten Primärkreis verbunden ist um einer Primärwicklung (8) des genannten Transformators Gleichstromimpulse bei einer die Frequenz zu messender dynamischer Vorgänge übersteigenden Frequenz aus dem genannten Speisestromkreis zuzuführen, mit Messmitteln (23) variabler Impedanz die mit einer Sekundärwicklung (9) des genannten Transformators verbunden sind, und mit Mitteln zur Messung des Stromflusses im Primärstromkreis, welcher Stromfluss messgebend ist für die Impedanz des genannten Messmittel, dadurch gekennzeichnet, dass der genannte Gleichstromspeisestromkreis (7) spannungsstablisiert ist, derart dass seine Spannung unabhängig ist vom genannten Stromfluss in der genannten Primärwicklung (8), und dass ein Feldeffekttransistor (6) in Serie mit der genannten Primärwicklung (8) in den genannten Primärstromkreis geschaltet ist, wobei das Tor des genannten Transistors (6) mit dem genannten Oszillator (5) verbunden ist.

2. System nach Anspruch 1, worin der genannte Feldeffekttransistor ein VMOS-Transistor (6) ist.

3. System nach Anspruch 1 oder 2, worin Spannungsbegrenzungselemente wie Zenerdioden (4, 24) in den genannten Speisestromkreis (7) und parallel zu den Messmitteln (23) geschaltet sind, um unerwünschte Spannungsspitzen am Speiseeingang des Systems und über den Messmitteln abzuschneiden.

4. System nach einem der Ansprüche 1 bis 3, worin ein in den genannten Primärstromkreis geschalteter Widerstand (25) mit einem Tiefpassfilter (26—29) verbunden ist, welches an seinem Ausgang eine zum Stromfluss im genannten Primärstromkreis bzw. Widerstand proportionale Gleichspannung erzeugt.

5. System nach Anspruch 4, worin Spannungsbegrenzungselemente wie Zener-dioden (33) in den Ausgangskreis des genannten Tiefpassfilters (26—29) geschaltet sind, um übermässige Spannungsspitzen abzuschneiden.

6. System nach irgendeinem der Ansprüche 1 bis 5, worin ein Impedanztransformator (16—21) zwischen die Sekundärwicklung (9) und die Messmittel (23) geschaltet ist.

7. System nach irgendeinem der Ansprüche 1 bis 6, worin ein Gleichrichter (12—15) mit der genannten Sekundärwicklung (9) verbunden ist, wobei die Messmittel (23) mit der gleichgerichteten Gleichspannung gespeist werden.

8. System nach irgendeinem der Ansprüche 1 bis 7, worin die Messmittel eine steuerbare Stromquelle (41) aufweisen, wobei ein Messkreis (23, 40) mit dem Steuereingang dieser Stromquelle verbunden ist.

9. System nach irgendeinem der Ansprüche 1 bis 8, worin der genannte Transformator (8—10) eine dritte Wicklung (10) in Serie mit einer Diode (11) aufweist, wobei die Serieschaltung dieser dritten Wicklung und der Diode parallel zur Primärwicklung (8) geschaltet ist, um Strom zurückzugewinnen und Spannungsspitzen während des Zusammenbruchs des Stroms in der Primärwicklung abzuschneiden.

FIG.1

FIG.2